# EUROPEAN PATENT APPLICATION

(11) **EP 4 769 851 A1**
(43) Date of publication of application: **01.07.2026**
(21) Application number: 25210642.2
(22) Date of filing: 23.10.2025
(51) Int. Cl.: H02B 1/015, H02B 1/04

(54) **GRID-CONNECTED DISTRIBUTION BOX**

(30) Priority: 24.12.2024 KR 20240195374
(71) Applicant: Hanwha Solutions Corporation, Jung-gu Seoul 04541 (KR)
(72) Inventor: HAM, Joung Hee, 04541 Seoul (KR); SEO, Seong Won, 04541 Seoul (KR); KIM, Kyoung Hwan, 04541 Seoul (KR)
(74) Representative: Mooser, Sebastian Thomas

(57) **Abstract**

Provided is a grid-connected distribution box including a case (10) having an internal space, a grid module (100) disposed in the internal space and having a main input terminal (110) to which main power is input, a control module (300) disposed adjacent to the grid module (100) and having a control board (310) connected to the grid module (100) and a sub-input terminal (330) to which at least one sub-power is input, a transformer (700) installed in the internal space, connected to the control board (310), and configured to convert a voltage, and a signal processing module (600) disposed on the transformer (700) to overlap the transformer (700), connected to the control board (310), and configured to process an electrical signal.

## Description

### BACKGROUND

### 1. Field

The present disclosure relates to a grid-connected distribution box having a fixed structure for a signal processing module.

### 2. Description of the Related Art

As a distribution box is recognized as an electrical device for branching and distributing power to a plurality of power consumers, the distribution box traditionally includes a metal enclosure, a main circuit breaker connected to a power grid, a plurality of branch circuit breakers, and a busbar connecting these components.

Recent distribution boxes have evolved beyond simple power distribution functions and are implementing various intelligent functions according to the purpose thereof. For example, there are grid-connected distribution boxes that are connected to a plurality of power grids to mutually exchange power.

However, constituent parts of distribution boxes of the related art have been assembled in the order of a production process and disposed to be coplanar with each other, and thus when parts related to communication processing and voltage conversion are installed inside an enclosure, a non-utilizable space has been generated inside the enclosure, which reduces space utilization. In some embodiments, due to a deep placement of a working position, there has been a disadvantage in that there is a possibility of misassembly and post-processing processes are complicated.

### SUMMARY

The present disclosure is directed to providing a grid-connected distribution box in which space utilization is improved, and ease of work is improved.

An aspect of the present disclosure provides a grid-connected distribution box including a case having an internal space, a grid module disposed in the internal space and having a main input terminal to which main power is input, a control module disposed adjacent to the grid module and having a control board connected to the grid module and a sub-input terminal to which at least one sub-power is input, a transformer installed in the internal space, connected to the control board, and configured to convert a voltage, and a signal processing module disposed on the transformer to overlap the transformer, connected to the control board, and configured to process an electrical signal.

In some embodiments, the signal processing module may include a base plate installed on the transformer, a board mount which is disposed on the base plate and on which a first signal processing board is seated, and a shielding cover covering an upper portion of the board mount.

In some embodiments, a second signal processing board may be mounted on the base plate to be adjacent to the board mount and the shielding cover.

In some embodiments, the shielding cover may have an electrical wire hole through which a conducting wire connecting the first signal processing board to the second signal processing board passes.

In some embodiments, an internal space provided by assembling the board mount and the shielding cover may form a shielding space configured to block electromagnetic wave radiation from the first signal processing board.

In some embodiments, the shielding cover may include aluminum.

In some embodiments, the shielding cover may have at least one electrical wire hole through which a conducting wire connecting the control board to the first signal processing board passes.

In some embodiments, the signal processing module may be spaced apart from an inner peripheral surface of the case by a preset height.

In some embodiments, the signal processing module may have a notch section in which a portion of the base plate installed on the transformer is cut to expose a plurality of terminals of the transformer.

In some embodiments, the grid-connected distribution box may further include a neutral module disposed adjacent to the control module to face the signal processing module.

In some embodiments, the neutral module and the signal processing module may be disposed at opposite sides of the control module, and the grid module may be disposed along a side of the control module between the neutral module and the signal processing module.

### BRIEF DESCRIPTION OF THE DRAWINGS

The above and other aspects, features, and advantages of certain embodiments of the disclosure will be more apparent from the following description taken in conjunction with the accompanying drawings in which:
FIG. 1 is a schematic block diagram illustrating a grid-connected distribution box according to an embodiment of the present disclosure;
FIG. 2 is a perspective view illustrating an embodiment of the grid-connected distribution box;
FIG. 3 is an exploded perspective view of a part of the grid-connected distribution box of FIG. 2;
FIG. 4 is a view illustrating a grid module and a relay module of FIG. 3;
FIG. 5 is a cross-sectional view taken along line V-V' of FIG. 3 when the grid module and the relay module are assembled;
FIG. 6 is a view illustrating a control module of FIG. 3;
FIG. 7 is a view illustrating a neutral module of FIG. 3;
FIG. 8 is a view illustrating a cross section of adjacent portions of the control module and the neutral module;
FIG. 9 is an exploded perspective view of a signal processing module and a transformer of FIG. 2;
FIG. 10 is a view illustrating in which the signal processing module and the transformer are assembled in the grid-connected distribution box of FIG. 2;
FIG. 11 is an enlarged view of part A shown in FIG. 10; and
FIG. 12 is a schematic diagram illustrating a circuit of the grid-connected distribution box of FIG. 2.

### DETAILED DESCRIPTION

Since the present disclosure may apply various transformations and have various embodiments, specific embodiments will be illustrated in the drawings and described in detail in the detailed description. Effects and features of the present disclosure, and methods for achieving them will become clear with reference to the embodiments described below in detail together with the drawings. However, the present disclosure is not limited to the embodiments disclosed below and may be implemented in various forms.

Hereinafter, embodiments of the present disclosure will be described in detail with reference to the attached drawings. When describing with reference to the drawings, identical or corresponding components are given the same drawing reference numerals and redundant descriptions thereof are omitted.

In the following embodiments, the terms first, second, and the like do not have limited meaning but are used for the purpose of distinguishing one component from another component.

In the following embodiments, the expressions used in the singular such as "a," "an," and "the" are intended to include the plural forms as well, unless the context clearly indicates otherwise.

In the following embodiments, it will be understood that the terms such as "including," "comprising," and "having" specify the presence of stated features or components, but do not preclude the presence or addition of one or more other features or components.

In the following embodiments, when an area, a component, or the like is positioned on or above another part, the present disclosure includes not only a case in which the area, the component, or the like is positioned directly above the other part, but also a case in which other areas, other components, or the like may be positioned therebetween.

In the drawings, components may be exaggerated or reduced in size for convenience of description. For example, the size and thickness of each component shown in the drawing are arbitrarily shown for convenience of description, and thus the present disclosure is not necessarily limited to what is shown.

In the following embodiments, it will be understood that when an area, a component, or the like is referred to as being connected to another component, it may be directly connected to the other component or intervening components may also be present.

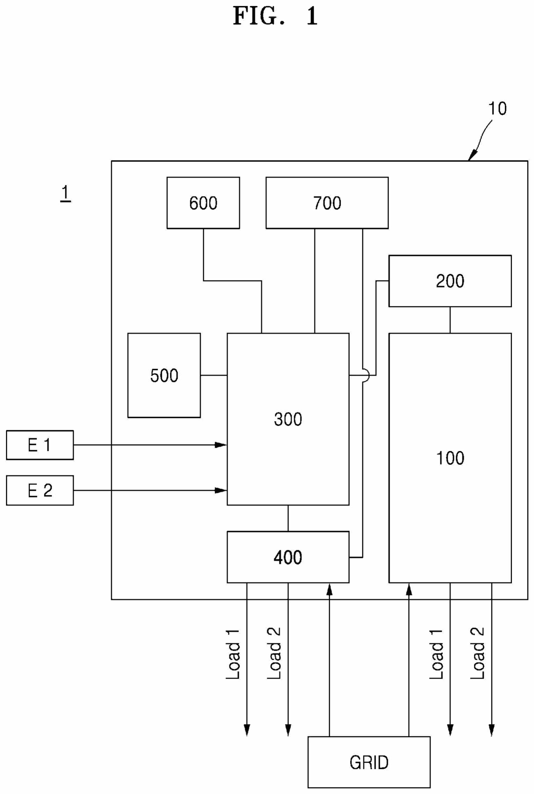

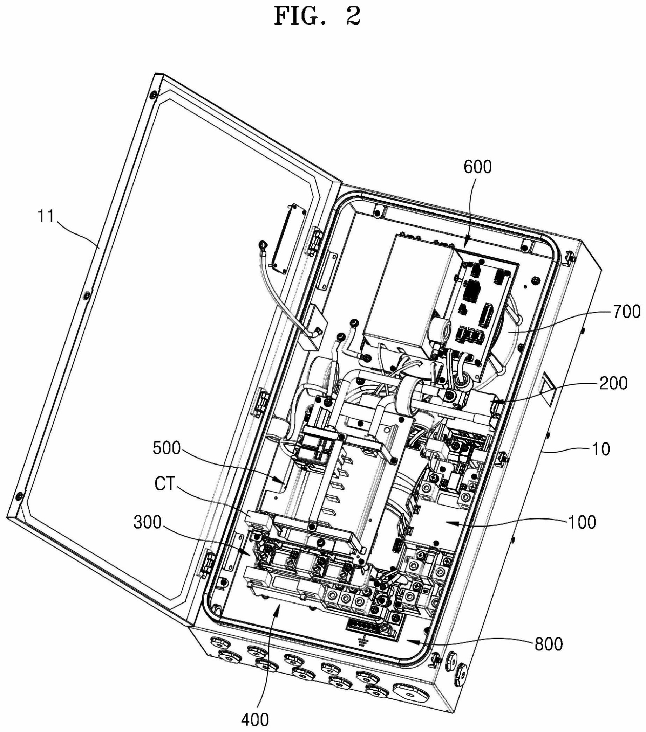

FIG. 1 is a schematic block diagram illustrating a grid-connected distribution box 1 according to an embodiment of the present disclosure. FIG. 2 is a perspective view illustrating an embodiment of the grid-connected distribution box 1.

Referring to FIG. 1, the grid-connected distribution box 1 may be electrically connected to a main power supply GRID, one or more sub-power supplies E1 and E2, and a plurality of loads Load 1 and Load 2, and may control power flow. The grid-connected distribution box 1 may distribute power input from the main power supply GRID or the sub-power supplies E1 and E2 and supply the input power to the loads Load 1 and Load 2.

According to an embodiment, the main power supply GRID may be a power grid that includes an infrastructure system for generating, transmitting, and distributing power. For example, the main power supply GRID may include a power plant, a substation, a power line network, and the like.

The sub-power supplies E1 and E2 may be provided as power supplies or systems that are different types from the main power supply GRID.

As an example, the sub-power supplies E1 and E2 may be provided as photovoltaic power generation systems. The sub-power supplies E1 and E2 may be the photovoltaic power generation systems each including a photovoltaic module and devices connected thereto. The photovoltaic module is a power generation device installed on a roof or exterior wall of a building and converts solar light into electrical energy through a photovoltaic effect. The device may be a power conditioning system (PCS) or power conversion system (PCS) that performs power conversion on power generated by the photovoltaic module. In some embodiments, the device may be a module level power electronics (MLPE). The device may be an optimizer or a micro-inverter (MI).

Optionally, the sub-power supplies E1 and E2 may each further include a coupler connected to the device. At least some of the devices may be connected to the grid-connected distribution box 1 through the coupler. For example, the coupler may combine powers output from a plurality of devices into one output power. The powers combined by the coupler may be supplied to the grid-connected distribution box 1.

As another example, the sub-power supplies E1 and E2 may be provided as energy storage systems (ESSs). The sub-power supplies E1 and E2 may store power generated by the photovoltaic module or power supplied from a power grid and may supply power to the grid-connected distribution box 1 according to the needs of the loads Load 1 and Load 2, thereby efficiently supplying power. The sub-power supplies E1 and E2 may each include a battery for storing power and a power conversion module. The power conversion module may be a PCS that performs conversion between battery-side power and opposite-side power. In this case, the PCS may include a bidirectional direct current (DC)-to-DC converter that is connected to the battery to convert a voltage, and a bidirectional inverter that connects the bidirectional DC-to-DC converter to a device outside the ESS.

The loads Load 1 and Load 2 each refer to a device that is installed in an electric power consumer such as a house, a commercial facility, or a factory and operated by receiving electric energy distributed through the grid-connected distribution box 1. That is, the loads Load 1 and Load 2 may include various types of devices, equipment, facilities, and the like that operate by receiving electric energy supplied from the main power supply GRID or the sub-power supplies E1 and E2.

The grid-connected distribution box 1 according to an embodiment of the present disclosure may be connected to a power grid that is the main power supply GRID, may be connected to a photovoltaic power generation system that is a first sub-power supply E1, and may be connected to an ESS that is a second sub-power supply E2. The grid-connected distribution box 1 may control a voltage, a current, and/or power output from or supplied to each component according to a power supply state of the main power supply GRID and/or the sub-power supplies E1 and E2.

Referring to FIGS. 1 and 2, in the grid-connected distribution box 1, a case 10 having an internal space may be provided to be opened or closed by a cover 11, and parts may be disposed in the internal space of the case 10.

The grid-connected distribution box 1 may include a grid module 100, a relay module 200, a control module 300, a neutral module 400, a blocking module 500, a signal processing module 600, and a transformer 700 inside the case 10.

The grid module 100 may be disposed inside the case 10, may be connected to the main power supply GRID, and may supply power to at least one load. The grid module 100 may receive power from the main power supply GRID and may distribute the power to at least one load. For example, the grid module 100 may supply power to a first load Load 1 and/or a second load Load 2.

The relay module 200 may be disposed at one side of the grid module 100 and may be assembled with the grid module 100. The relay module 200 may be electrically connected to the control module 300. The relay module 200 may control power supply to the grid module 100 by the control module 300. The relay module 200 may connect or disconnect a power circuit according to a control signal of the control module 300.

The control module 300 may be connected to at least one sub-power supply. For example, the control module 300 may be connected to at least one of the first sub-power supply E1 and the second sub-power supply E2 to receive power.

The sub-power supply may be provided as an emergency power supply for a generator device, a power generation system inverter, or an ESS. However, one or more embodiments are not limited thereto, and any power supply may be applied as the sub-power supply as long as the power supply may supply stable alternating current (AC) power to the control module 300.

The control module 300 may be connected to the relay module 200 and may perform control such that power supplied from the sub-power supply is transmitted to the grid module 100 through the relay module 200. By the control module 300, the grid module 100 may transmit power supplied from the sub-power supply to a load.

The neutral module 400 may be electrically connected to the control module 300 and may be disposed adjacent to the grid module 100. The neutral module 400 may be connected to a neutral line of the main power supply GRID and a neutral line of the load, thereby fixing the neutral lines.

In an embodiment, the grid module 100 may be connected to an active line of the main power supply GRID so that power may be input. The grid module 100 may be connected to active lines of the loads Load 1 and Load 2 so that power may be output. In this case, the neutral module 400 may be connected to a common neutral line of the main power supply GRID so that power may be input. The neutral module 400 may be connected to the loads Load 1 and Load 2 so that power may be output. The grid-connected distribution box 1 may receive and distribute power at a constant voltage by a phase voltage generated between the active line and the neutral line.

The blocking module 500 may include a typical circuit breaker to block a power transfer in the grid-connected distribution box 1. The blocking module 500 may be electrically connected to the control module 300, and when an abnormality occurs in power supply, the power supply may be stopped by the blocking module 500.

According to an embodiment, the blocking module 500 may be disposed on the control module 300 to overlap the control module 300. As shown in FIG. 2, the blocking module 500 may be disposed and layered on the control module 300 so that the grid-connected distribution box 1 may have a simple internal structure and a compact size.

The signal processing module 600 may be electrically connected to the control module 300 and may perform signal processing according to a control signal. The signal processing module 600 may convert power applied by the main power supply GRID or the sub-power supplies E1 and E2. In some embodiments, the signal processing module 600 may control compatibility with different electrical circuits or external systems. The signal processing module 600 will be described in detail below.

The transformer 700 may be disposed in the internal space of the case 10. As an example, the transformer 700 may be provided as a typical autotransformer. The transformer 700 may be connected to the control module 300 and may supply split-phase power to the first load Load 1 and the second load Load 2 from the grid module 100 according to a control signal.

In this case, a heat dissipation structure (not shown) may be formed on a surface of the case 10 facing the transformer 700. The heat dissipation structure may be provided in a shape integrated with the case 10. The heat dissipation structure may be provided to externally dissipate heat generated when the transformer 700 and other internal parts operate.

According to an embodiment, the signal processing module 600 may be disposed to be spaced apart from an inner peripheral surface of the case 10 by a preset height. The signal processing module 600 may be disposed on the transformer 700 to overlap the transformer 700. As shown in FIG. 2, the signal processing module 600 may have a structure disposed on the transformer 700 to overlap the transformer 700, and thus when repair and replacement work are required for a corresponding portion, a working position may be provided at an upper side of the case 10, thereby improving work convenience. In some embodiments, due to an overlapping structure of the signal processing module 600 and the transformer 700, the grid-connected distribution box 1 may have a simple internal structure and a compact size.

Optionally, the grid-connected distribution box 1 may further include a grounding module 800. The grounding module 800 may connect an electric circuit to the ground through a conducting wire and may allow a current to flow to the ground. The grounding module 800 may allow a current to flow to the ground when an abnormal voltage occurs, thereby allowing a device to maintain the same potential.

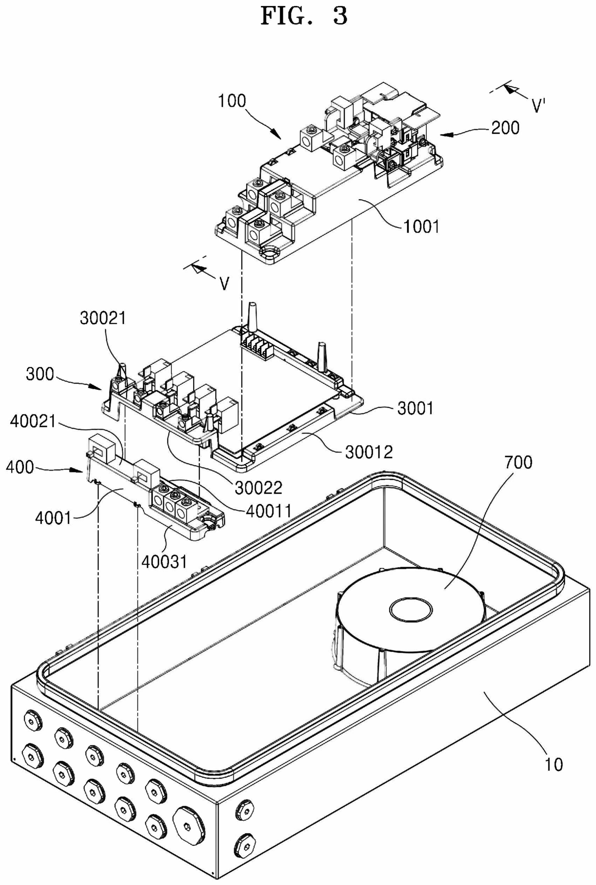

FIG. 3 is an exploded perspective view of a part of the grid-connected distribution box 1 of FIG. 2.

Referring to FIG. 3, the grid module 100, the relay module 200, the control module 300, and the neutral module 400 may be disposed adjacent to each other.

For convenience of description, hereinafter, in the grid-connected distribution box 1, a side at which the neutral module 400 is disposed is defined as a front side, and a side at which the transformer 700 is disposed is defined as a rear side.

The grid module 100 may have a first base body 1001, and the grid module 100 and the relay module 200 may be assembled so that the relay module 200 may be seated at one side of the first base body 1001.

The first base body 1001 may have a step difference. In some embodiments, the first base body 1001 may be formed in a shape extending in a longitudinal direction of the case 10 and may be disposed at a left side of the internal space of the case 10.

The control module 300 may have an approximately plate shape and may be disposed at a right side of the internal space of the case 10. The control module 300 may be disposed in parallel with the grid module 100 in a left-right direction.

The control module 300 may have a first base structure 3001 so that a first step 30021 on which at least one sub-input terminal is mounted may be formed at a front side thereof, and a grid module support 30012 adjacent to the grid module 100 may be formed at a side thereof.

The first step 30021 may be formed to protrude upward from a base surface of the first base structure 3001. A cut-out portion 30022 may be disposed below the first step 30021. The cut-out portion 30022 may form a space recessed from a front surface of the first base structure 3001. A second base structure 4001 of the neutral module 400 may be partially inserted into the cut-out portion 30022.

The first step 30021 may protrude from a bottom surface inside the case 10, and thus a sub-input terminal mounted on the first step 30021 may be positioned at an upper portion of the case 10. In some embodiments, when work of connecting a conducting wire to the sub-input terminal, a working position may be provided at the upper side of the case 10, and thus work convenience may be improved.

The grid module support 30012 may be provided in a block shape protruding upward from the base surface of the first base structure 3001. The grid module support 30012 may be inserted into a side surface of the first base body 1001.

According to an embodiment, facing surfaces of the first base body 1001 and the first base structure 3001 may correspond to each other. The grid module support 30012 may be inserted into a right side surface of the first base body 1001. Thus, the grid module 100 and the control module 300 may at least partially overlap each other to be installed more compactly.

The neutral module 400 may be formed in a shape extending in a width direction of the case 10 and may be disposed at a front side of the internal space of the case 10. The neutral module 400 may be disposed adjacent to the control module 300 in a front-rear direction.

The neutral module 400 may have the second base structure 4001 so that a second step 40021 may be provided at one side of a second plate 40011, and a neutral terminal mount 40031 may be provided at the other side of the second plate 40011.

The second step 40021 may be disposed at one side of a front surface of the second base structure 4001. The second step 40021 may be formed to protrude upward from the second plate 40011 of the second base structure 4001.

The neutral terminal mount 40031 may be disposed at the other side of the second base structure 4001. The neutral terminal mount 40031 may be provided on the second plate 40011 of the second base structure 4001.

In the second base structure 4001, the second plate 40011 may be inserted into the cut-out portion 30022 of the first base structure 3001.

According to an embodiment, facing surfaces of the first base structure 3001 and the second base structure 4001 may correspond to each other. The second plate 40011 of the second base structure 4001 may be inserted into the cut-out portion 30022 of the first base body 1001. Thus, the control module 300 and the neutral module 400 may at least partially overlap each other to be installed more compactly.

According to an embodiment, the second plate 40011 of the neutral module 400 may be disposed to overlap the first step 30021 of the control module 300. The grid module support 30012 of the control module 300 may be inserted into a side surface of the grid module 100. The relay module 200 may be assembled onto the grid module 100.

Accordingly, in the grid-connected distribution box 1 according to an embodiment, internal modules may be installed more compactly because the grid module 100, the relay module 200, the control module 300, and the neutral module 400 partially overlap each other.

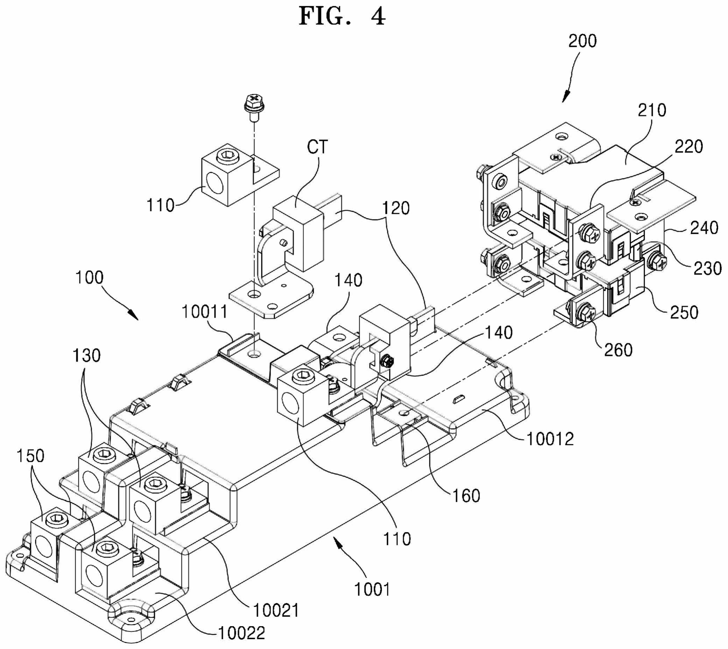

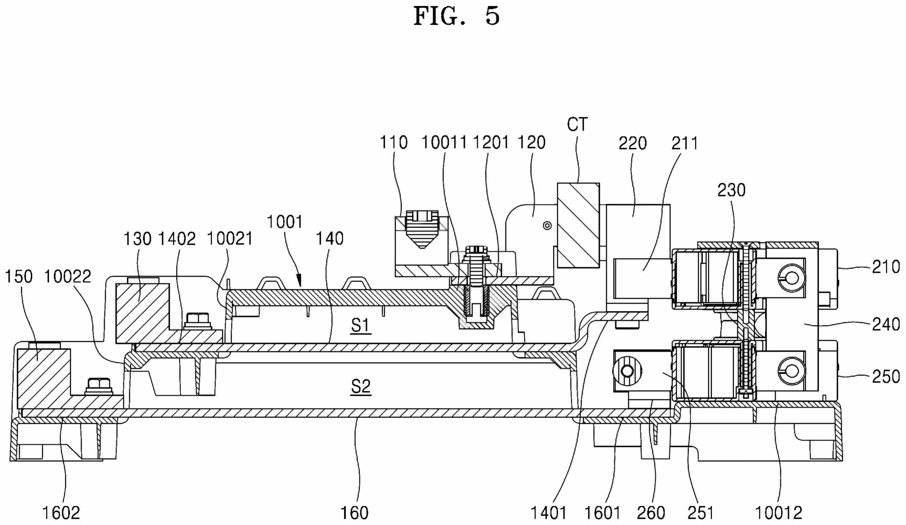

FIG. 4 is a view illustrating the grid module 100 and the relay module 200 of FIG. 3. FIG. 5 is a cross-sectional view taken along line V-V' of FIG. 3 when the grid module 100 and the relay module 200 are assembled.

Referring to FIGS. 1 to 5, the grid module 100 and the relay module 200 may be assembled to each other to form an electric circuit.

The grid module 100 may include the first base body 1001 having a step difference, and a main input terminal 110 and one or more output terminals 130 and 150 which are disposed at different levels along the step difference.

The grid module 100 may include the main input terminal 110, a main input tab 120, a first output terminal 130, a first connector 140, a second output terminal 150, and a second connector 160.

According to an embodiment, the first base body 1001 may include a main terminal mount 10011 forming an upper surface thereof, a first output terminal mount 10021 disposed below the main terminal mount 10011, and a second output terminal mount 10022 disposed below the first output terminal mount 10021.

The main input terminal 110 may be mounted on the main terminal mount 10011, the first output terminal 130 may be mounted on the first output terminal mount 10021, and the second output terminal 150 may be mounted on the second output terminal mount 10022. That is, due to a structure of the first base body 1001, the main input terminal 110, the first output terminal 130, and the second output terminal 150 may be disposed at different levels.

In another embodiment, the main input terminal 110 may be disposed on any one output terminal mount of the first output terminal mount 10021 and the second output terminal mount 10022, and the first output terminal 130 and the second output terminal 150 may be disposed on the remaining output terminal mount and the main terminal mount 10011.

The first base body 1001 may include an insulating material. Thus, the main input terminal 110, the first output terminal 130, and the second output terminal 150 installed on the first base body 1001 may form an electric circuit and prevent leakage current.

The first base body 1001 may include a heat-resistant and chemical-resistant material. Thus, the physical or chemical deformation of the first base body 1001 due to heat generated from the main input terminal 110, the first output terminal 130, and the second output terminal 150 installed on the first base body 1001 may be prevented.

The grid module 100 may form an electric circuit connected to the relay module 200 through the main input terminal 110, the main input tab 120, the first output terminal 130, the first connector 140, the second output terminal 150, and the second connector 160 installed on the first base body 1001.

The main input terminal 110 may be directly connected to the main power supply GRID so that power may be applied. The main input terminal 110 may be connected to the active line of the main power supply GRID. The main input terminal 110 may be connected to the relay module 200 through the main input tab 120.

The main input tab 120 may be disposed on the main terminal mount 10011. The main input terminal 110 may be mounted on the main input tab 120. The main input tab 120 may have one end portion connected to the main input terminal 110 and the other end portion connected to a first relay tab 220 of the relay module 200. Power input to the main input terminal 110 may be transmitted to the relay module 200 through the main input tab 120.

As a specific example, the main input terminal 110 may have a tab fixing portion 1201 having a plate shape so that the tab fixing portion 1201 may be disposed on the main terminal mount 10011. The main input terminal 110 may be seated on the tab fixing portion 1201. In this case, the other end portion of the main input tab 120 may be formed in a shape extending from the tab fixing portion 1201 toward the first relay tab 220.

The main input tab 120 may further include a current sensor CT. A current input to the main input terminal 110 may be measured at the main input tab 120 by the current sensor CT.

The first output terminal 130 may be connected to the first load Load 1 to supply power. The first output terminal 130 may be connected to the active line of the first load Load 1. The first output terminal 130 may be connected to the relay module 200 through the first connector 140.

The first connector 140 may be disposed on the first output terminal mount 10021. A first opening S1 may be formed to pass through the first output terminal mount 10021 in a longitudinal direction so that the first connector 140 may be inserted into the first opening S1. The first connector 140 may be formed in a shape extending through the first opening S1.

The first connector 140 may have one end portion connected to the first relay tab 220 of the relay module 200 and the other end portion connected to the first output terminal 130. The first connector 140 may form a circuit that connects the main input terminal 110 to the first output terminal 130 through the first relay tab 220. Accordingly, power supplied from the main power supply GRID may be distributed to the first load Load 1.

In some embodiments, the other end portion of the first connector 140 may be bent upward. The first connector 140 may have a bent end portion 1401 bent upward and a straight line end portion 1402 extending in a straight line at a side opposite to the bent end portion 1401. Due to a shape of the bent end portion 1401, the first connector 140 may be fastened to the first relay tab 220 above a bottom surface of the first output terminal mount 10021, and may have a large separation distance from the second connector 160.

The second output terminal 150 may be connected to the second load Load 2 to supply power. The second output terminal 150 may be connected to the active line of the second load Load 2. The second output terminal 150 may be connected to the relay module 200 through the second connector 160.

The second connector 160 may be disposed on the second output terminal mount 10022. A second opening S2 may be formed to pass through the second output terminal mount 10022 in a longitudinal direction so that the second connector 160 may be inserted into the second opening S2. The second connector 160 may be formed in a shape extending through the second opening S2.

The second connector 160 may have one end portion connected to a second relay tab 260 of the relay module 200 and the other end portion connected to the second output terminal 150. The second connector 160 may form a circuit connecting the relay module 200 and the second output terminal 150, thereby allowing power transmitted through the relay module 200 to be distributed to the second load Load 2.

In some embodiments, the second connector 160 may be provided as a linear terminal extending in both directions and thus may have a relay-side end portion 1601 and a load terminal-side end portion 1602. The second connector 160 may be mounted on a bottom surface of the second output terminal mount 10022 and may be installed stably.

According to an embodiment, the second connector 160 may have a different length from the first connector 140. A length of the second connector 160 may be greater than a length of the first connector 140. In this case, in the first base body 1001, a length of the second output terminal mount 10022 may be greater than a length of the first output terminal mount 10021.

Accordingly, inside the case 10, the first output terminal 130 may be disposed behind the second output terminal 150, and at a side opposite to the first output terminal 130, the relay-side end portion 1601 of the second connector 160 may be positioned behind the bent end portion 1401 of the first connector 140.

Due to a shape of the first base body 1001 and a length difference between the first connector 140 and the second connector 160, during an assembly process of the grid module 100, an operation of assembling the second output terminal 150 to the second connector 160 and an operation of assembling the first output terminal 130 to the first connector 140 may each be easily performed.

In some embodiments, during an assembly process of the grid module 100 and the relay module 200, an operation of connecting the second relay tab 260 to the relay-side end portion 1601 of the second connector 160 and an operation of connecting the first relay tab 220 to the bent end portion 1401 of the first connector 140 may each be easily performed.

The first base body 1001 of the grid module 100 may further include a relay mount 10012 protruding from a surface of the second output terminal mount 10022. The relay mount 10012 may support the relay module 200.

When the relay module 200 is assembled with the grid module 100, the relay module 200 may be seated on the relay mount 10012 so that an assembly portion with the grid module 100 may be stably supported.

When one side of the relay module 200 is assembled with the grid module 100, the other side of the relay module 200 may be connected to the control module 300. The relay module 200 may receive power from the first sub-power supply E1 or the second sub-power supply E2 connected to the control module 300.

The relay module 200 may output power input to the main input terminal 110 to the first output terminal 130 and may output power input by the control module 300 to the second output terminal 150. That is, the relay module 200 may separate a circuit that supplies power from a main power supply to a load from a circuit that supplies power from a sub-power supply to a load.

The relay module 200 may include a first relay 210, the first relay tab 220, a spacer 230, a connection tab 240, a second relay 250, and the second relay tab 260.

The relay module 200 may include the first relay 210 and the second relay 250 that are vertically stacked. In the relay module 200, the first relay 210 may be connected to the first relay tab 220 to form an electric circuit, and the second relay 250 may be connected to the second relay tab 260 to form an electric circuit.

According to an embodiment, the first relay 210 may assemble the first relay tab 220 to a first relay tab supporter 211. The first relay tab 220 may connect the main input tab 120 and the first connector 140 of the grid module 100 to each other to form a power supply circuit of the main power supply GRID.

In this case, the second relay 250 may assemble the second relay tab 260 to a second relay tab supporter 251. The second relay tab 260 may be connected to the second connector 160 of the grid module 100 to form a power supply circuit for power of the first sub-power supply E1 or the second sub-power supply E2 transmitted from the control module 300 to the relay module 200.

The connection tab 240 may have a shape vertically extending to connect the first relay 210 to the second relay 250. In this case, the spacer 230 may be disposed between the first relay 210 and the second relay 250 to support the first relay 210 and the second relay 250 and maintain a separation space.

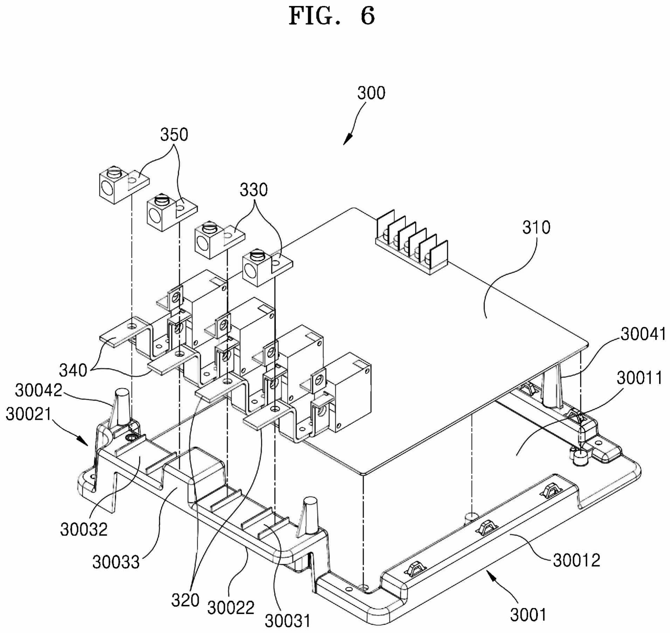

FIG. 6 is a view illustrating the control module 300 of FIG. 3.

Referring to FIGS. 1 and 6, the control module 300 may include the first base structure 3001, and a control board 310, a first sub-input tab 320, a first sub-input terminal 330, a second sub-input tab 340, and a second sub-input terminal 350 which are disposed on the first base structure 3001.

The first base structure 3001 may include an insulating material. Thus, the control board 310, the first sub-input terminal 330, and the second sub-input terminal 350 installed on the first base structure 3001 may form an electric circuit and prevent leakage current.

The first base structure 3001 may include a heat-resistant and chemical-resistant material. Thus, the physical or chemical deformation of the first base structure 3001 due to heat generated from the control board 310, the first sub-input terminal 330, and the second sub-input terminal 350 installed on the first base structure 3001 may be prevented.

According to an embodiment, the first base structure 3001 may include a first plate 30011, the grid module support 30012, the first step 30021, a first column 30041, and a second column 30042.

The first base structure 3001 may have a step difference so that the control board 310 and the first and second sub-input terminals 330 and 350 may be positioned at different levels and disposed not to overlap each other.

The cut-out portion 30022 of the first step 30021 and the grid module support 30012 have been described with reference to FIG. 3, and thus descriptions thereof will be omitted below.

The first plate 30011 may have a flat plate shape, and the control board 310 may be disposed on the first plate 30011.

The control board 310 may be provided as a circuit board that generates an electrical signal for controlling the grid-connected distribution box 1. The control board 310 may generate control signals for the grid module 100, the relay module 200, the control module 300, the neutral module 400, the blocking module 500, the signal processing module 600, and the transformer 700.

For example, the control board 310 may measure input sub-power at the first sub-input terminal 330 and the second sub-input terminal 350. In some embodiments, the control board 310 may control the relay module 200 to switch a power supply circuit, thereby controlling power transmitted to a load. In some embodiments, the control board 310 may control the blocking module 500 to block a current when an abnormality occurs in the current input to or output from the grid module 100 and the neutral module 400. In some embodiments, the control board 310 may control the signal processing module 600 to process an electrical signal generated inside the grid-connected distribution box 1 or input from the outside. In some embodiments, the control board 310 may control the transformer 700 to transform a current input to or output from the grid-connected distribution box 1.

The first step 30021 may protrude from one side of the first plate 30011 in a height direction and may support the first sub-input terminal 330 and the second sub-input terminal 350. In some embodiments, the first step 30021 may have a first sub-terminal mount 30031 and a second sub-terminal mount 30032.

The first sub-input terminal 330 may be disposed on the first sub-terminal mount 30031, and the second sub-input terminal 350 may be disposed on the second sub-terminal mount 30032.

A protruding block 30033 may be disposed between the first sub-terminal mount 30031 and the second sub-terminal mount 30032. The protruding block 30033 may be formed to protrude from a surface of the first step 30021.

The protruding block 30033 may define the first sub-terminal mount 30031 and the second sub-terminal mount 30032. The first sub-input terminal 330 and the second sub-input terminal 350 may be supported on the first step 30021 by the protruding block 30033 and fixed in place. In some embodiments, the first sub-input terminal 330 and the second sub-input terminal 350 may be separated by the protruding block 30033 so that interference between circuits may be prevented.

The first column 30041 may be formed to protrude from the first plate 30011 in a height direction, and the second column 30042 may be formed to extend from the first step 30021. Uppermost ends of the first column 30041 and the second column 30042 may be formed to have the same height. The blocking module 500 may be installed on the first column 30041 and the second column 30042.

According to an embodiment, power may be input to the control module 300 through the first sub-input tab 320, the first sub-input terminal 330, the second sub-input tab 340, and the second sub-input terminal 350.

The first sub-input terminal 330 may be connected to the first sub-power supply E1 so that power may be applied. The first sub-input terminal 330 may be connected to an active line of the first sub-power supply E1. The first sub-input terminal 330 may be installed on the first sub-input tab 320.

The first sub-input tab 320 may be disposed on the first sub-terminal mount 30031. The first sub-input tab 320 may have one end portion connected to the first sub-input terminal 330 and the other end portion connected to the control board 310. In some embodiments, the first sub-input tab 320 may be connected to the relay module 200 through a conducting wire and may form a circuit for power transmitted to the relay module 200 under the control of the control board 310.

The second sub-input terminal 350 may be connected to the second sub-power supply E2 so that power may be applied. The second sub-input terminal 350 may be connected to an active line of the second sub-power supply E2. The second sub-input terminal 350 may be installed on the second sub-input tab 340.

The second sub-input tab 340 may be disposed on the second sub-terminal mount 30032. The second sub-input tab 340 may have one end portion connected to the second sub-input terminal 350 and the other end portion connected to the control board 310. In some embodiments, the second sub-input tab 340 may be connected to the relay module 200 through a conducting wire and may form a circuit for power transmitted to the relay module 200 under the control of the control board 310.

According to an embodiment, the first sub-input tab 320 and the second sub-input tab 340 may be bent upward. The first sub-input tab 320 and the second sub-input tab 340 may be bent to correspond to a step difference between the first plate 30011 and the first step 30021. That is, the first sub-input tab 320 and the second sub-input tab 340 may be bent along a shape of the first step 30021 so that one end portions thereof may be disposed on the first step 30021, and the other end portions thereof may be disposed on the control board 310.

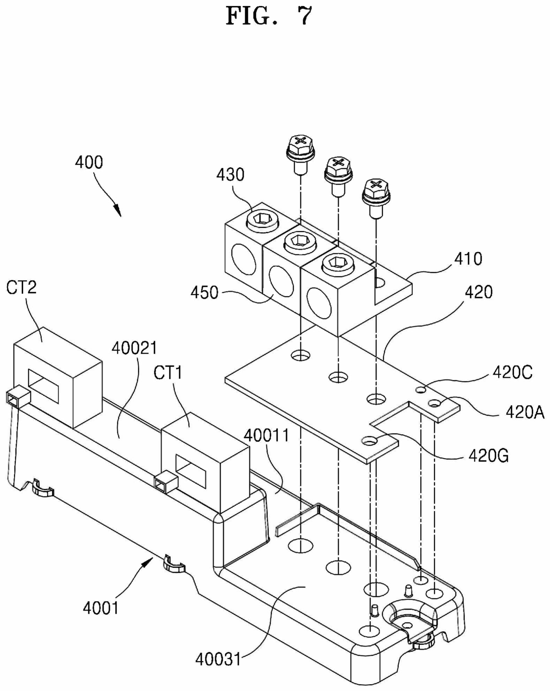

FIG. 7 is a view illustrating the neutral module 400 of FIG. 3.

Referring to FIGS. 1 and 7, the neutral module 400 may include the second base structure 4001, and a neutral input terminal 410, a neutral connection tab 420, a first neutral output terminal 430, and a second neutral output terminal 450 which are disposed on the second base structure 4001.

The neutral module 400 may be disposed adjacent to the control module 300 and may have the neutral input terminal 410 connected to the main power supply GRID and one or more neutral output terminal 430 and 450 connected to one or more loads.

The second base structure 4001 may include an insulating material. Thus, the neutral input terminal 410, the first neutral output terminal 430, and the second neutral output terminal 450 installed on the second base structure 4001 may form an electric circuit and prevent leakage current.

The second base structure 4001 may include a heat-resistant and chemical-resistant material. Thus, the physical or chemical deformation of the second base structure 4001 due to heat generated from the neutral input terminal 410, the first neutral output terminal 430, and the second neutral output terminal 450 installed on the second base structure 4001 may be prevented.

According to an embodiment, the second base structure 4001 may include the second plate 40011, the second step 40021, and the neutral terminal mount 40031.

The second plate 40011 may have a flat plate shape extending in a left-right direction and may be partially inserted into the cut-out portion 30022 of the control module 300.

The second step 40021 may be formed by a portion of a surface of the second plate 40011 protruding in a height direction. The second step 40021 may support at least one current sensor. For example, a first current sensor CT1 and a second current sensor CT2 may be disposed on the second step 40021.

The first current sensor CT1 and the second current sensor CT2 may each be provided as the same sensor as the above-described current sensor CT installed on the main input tab 120. However, it will be described that the current sensor CT, the first current sensor CT1, and the second current sensor CT2 are referred to differently for the purpose of distinction.

The neutral terminal mount 40031 may have a flat plate shape extending from the second plate 40011, thereby forming a space in which the neutral connection tab 420 is mounted.

The neutral connection tab 420 may be provided as a plate-shaped terminal having an area corresponding to the neutral terminal mount 40031, and the neutral input terminal 410, the first neutral output terminal 430, and the second neutral output terminal 450 may be mounted on the neutral connection tab 420.

The neutral input terminal 410 may be connected to the neutral line of the main power supply GRID so that a neutral line current may be input. The first neutral output terminal 430 may be connected to the active line of the first load Load 1, and the second neutral output terminal 450 may be connected to the active line of the second load Load 2 so that a neutral line current may be output to each load.

The neutral input terminal 410, the first neutral output terminal 430, and the second neutral output terminal 450 may be connected to each other through the neutral connection tab 420, thereby forming a circuit, through which a neutral line current flows, in the neutral module 400. Accordingly, a neutral current supplied from the main power supply GRID may be distributed to the first load Load 1 and the second load Load 2.

According to an embodiment, an edge of the neutral connection tab 420 may include a controller connection portion 420C, a transformer connection portion 420A, and a ground connection portion 420G.

The controller connection portion 420C may be connected to the control board 310 of the control module 300, and thus an input or output of a neutral line current in the neutral module 400 may be controlled. The transformer connection portion 420A may be connected to the transformer 700 so that a voltage of a neutral line current may be transformed. The ground connection portion 420G may be connected to the grounding module 800, thereby allowing a neutral line current to flow to the ground.

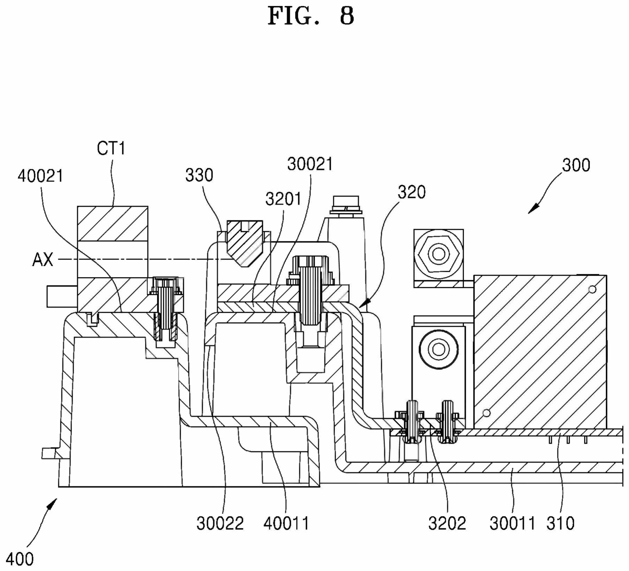

FIG. 8 is a view illustrating a cross section of adjacent portions of the control module 300 and the neutral module 400.

In some embodiments, FIG. 8 illustrates a cross section taken based on a mounting portion of the first sub-input terminal 330 and the first current sensor CT1, and the following description may be equally applied to a mounting portion of a second current sensor CT2 adjacent to the second sub-input terminal 350.

Referring to FIGS. 1 and 8, the control module 300 and the neutral module 400 may partially overlap each other to be disposed close to each other.

According to an embodiment, a width of the first step 30021 may be less than a width of the second base structure 4001. Accordingly, a portion of the second plate 40011 may be inserted into the cut-out portion 30022.

In some embodiments, when the second plate 40011 is inserted into the cut-out portion 30022, the second step 40021 may be disposed to face the first step 30021, and the neutral terminal mount 40031 may be partially disposed below the first step 30021.

According to an embodiment, the first current sensor CT1 and the first sub-input terminal 330 may be installed on a straight line along a first axis AX. A conducting wire connected from the first sub-power supply E1 to the first sub-input terminal 330 may pass through the first current sensor CT1 to be connected to the first sub-input terminal 330. Power supplied from the first sub-power supply E1 may be measured by the first current sensor CT1.

When a current sensed by the first current sensor CT1 is normal, power supplied from the first sub-power supply E1 may be input to the first sub-input terminal 330. When the first current sensor CT1 detects an abnormality such as an overcurrent, a current to the first sub-input terminal 330 may be blocked.

As described above, when power is normally input to the first sub-input terminal 330, power may be transmitted to the control board 310 connected to a control board-side end portion 3202 through a terminal-side end portion 3201 of the first sub-input tab 320.

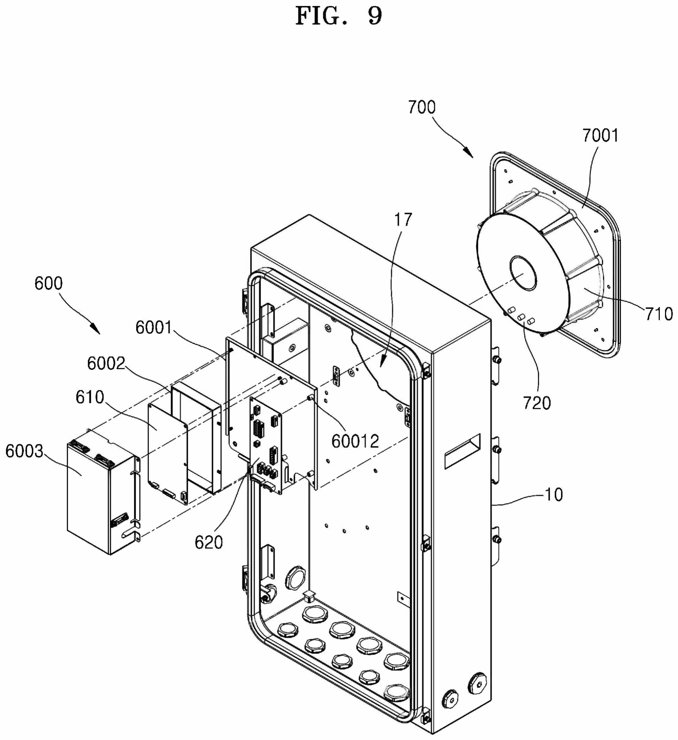

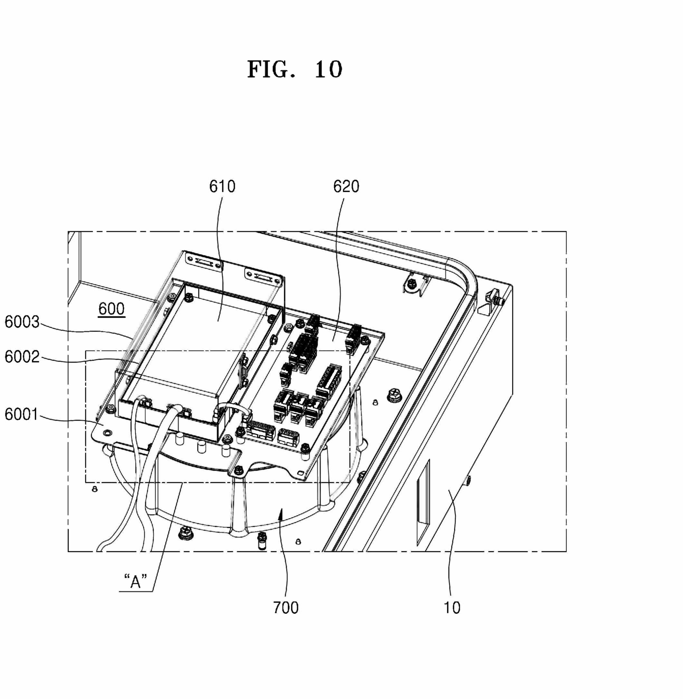

FIG. 9 is an exploded perspective view of the signal processing module 600 and the transformer 700 of FIG. 2. FIG. 10 is a view a state in which the signal processing module 600 and transformer 700 are assembled in the grid-connected distribution box 1 of FIG. 2.

Referring to FIGS. 1 to 10, the signal processing module 600 and the transformer 700 may be vertically stacked and assembled in a layered structure. The signal processing module 600 may be disposed on the transformer 700 to provide a space in which a first signal processing board 610 and a second signal processing board 620 are mounted.

The signal processing module 600 may perform power conversion or circuit compatibility according to a control signal of the control module 300. In some embodiments, the first signal processing board 610 may be connected to the control board 310 through a conducting wire to convert power input to the grid module 100 and the control module 300. The second signal processing board 620 may be connected to the control board 310 through a conducting wire and may make signals compatible between electric circuits formed in the grid module 100 and the control module 300.

According to an embodiment, the signal processing module 600 may include a plate having a flat plate shape, and a board mount 6002 and a shielding cover 6003 which are disposed at one side of an upper surface of the plate.

The board mount 6002 and the shielding cover 6003 may be coupled to each other to accommodate the first signal processing board 610. The first signal processing board 610 may radiate a large amount of electromagnetic waves while converting power. Therefore, in order to prevent interference with adjacent electrical components and circuits, it is essential that the first signal processing board 610 be shielded by the board mount 6002 and the shielding cover 6003.

The board mount 6002 and the shielding cover 6003 may be coupled to each other to form a shielding space that blocks electromagnetic wave radiation. The board mount 6002 and the shielding cover 6003 may include a material having an electromagnetic shielding effect or may be surface-treated.

As an example, the board mount 6002 and the shielding cover 6003 may include aluminum. Aluminum is a metallic material known to have a self-electromagnetic shielding effect. However, one or more embodiments are not limited thereto, and the board mount 6002 and the shielding cover 6003 may include different types of materials and may include an aluminum material that is applied or bonded onto surfaces thereof.

The signal processing module 600 may have a board installation part 60012 disposed at the other side of an upper surface of a base plate 6001. The board installation part 60012 may be formed as a protrusion protruding upward from the base plate 6001 and may be provided as a plurality of board installation parts 60012. The second signal processing board 620 may be mounted on the board installation part 60012, and thus the second signal processing board 620 may be spaced apart from the transformer 700 by a certain height to prevent electrical interference.

The transformer 700 may be assembled to pass through the case 10. The transformer 700 may include a transformer frame 7001 that is inserted into and fixed in a transformer hole 17, a transformer body 710 embedded at a central portion of the transformer frame 7001, and a transformer terminal area 720 to which a conducting wire connected to the transformer body 710 is connected.

The transformer 700 may perform voltage conversion according to a control signal of the control module 300. In some embodiments, the transformer 700 may be connected to the control board 310 through a conducting wire to adjust a voltage of power input to the grid module 100 and the control module 300.

According to an embodiment, the signal processing module 600 and the transformer 700 may be disposed adjacent to the control module 300. The signal processing module 600 and the transformer 700 may overlap each other to be disposed in a layered structure. Thus, the conducting wires through which the signal processing module 600 and the transformer 700 are connected to the control board 310 may be formed to be short and simple, and thus the convenience and efficiency of wiring work may be improved.

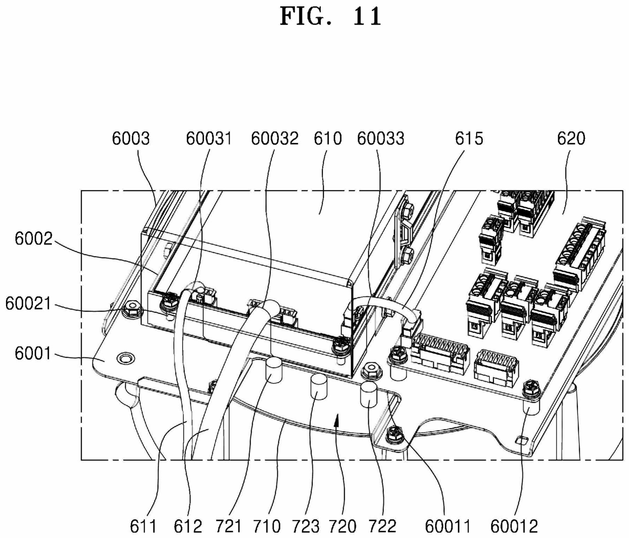

FIG. 11 is an enlarged view of part A shown in FIG. 10.

Referring to FIGS. 1 and 11, at least a portion of a surface of the signal processing module 600, which is in contact with the transformer 700, may be open, and the transformer terminal area 720 for connecting a conducting wire connected from the control module 300 to the transformer 700 may be exposed.

According to an embodiment, the base plate 6001 may be disposed to cover an upper surface of the transformer body 710 and may include a notch section 60011 exposing the transformer terminal area 720. The notch section 60011 may be provided in a shape of a notch formed by cutting a certain predetermined area from an edge of the base plate 6001. However, one or more embodiments are not limited thereto, and the base plate 6001 may have a through-hole perforated to expose the transformer terminal area 720.

The transformer terminal area 720 may be provided as a connection terminal electrically connected to the transformer body 710. The transformer terminal area 720 may have a plurality of terminals for connecting conducting wires connected to the control module 300.

As an embodiment, the transformer terminal area 720 may include a first conducting wire terminal 721, a second conducting wire terminal 722, and a third conducting wire terminal 723. The first conducting wire terminal 721 and the second conducting wire terminal 722 may be connected to conducting wires connected to the control module 300 and may receive a control signal related to an active line. The third conducting wire terminal 723 may be connected to a conducting wire connected to the control module 300 and may receive a control signal related to a neutral line. According to a control signal transmitted through the conducting wire connected to the transformer terminal area 720, the transformer 700 may adjust a voltage of power input or output from the grid-connected distribution box 1.

According to an embodiment, the first signal processing board 610 may be installed on an assembly pole 60021 provided inside the board mount 6002. The first signal processing board 610 may be embedded in the shielding space formed by the board mount 6002 and the shielding cover 6003.

The first signal processing board 610 may convert AC power into DC power or convert one DC power into DC power with a different voltage. As a specific example, the first signal processing board 610 may be provided as a switched-mode power supply (SMPS) board of the related art. The first signal processing board 610 may rapidly pulse an input voltage through a high-frequency switching method and then may convert such a pulse into a required voltage by using a transformer or another circuit.

The shielding cover 6003 may have at least one electrical wire hole through which a conducting wire connected from the control module 300 to the first signal processing board 610 passes. For electrical connection with the control module 300, a first control board-side conducting wire 611 and a second control board-side conducting wire 612 may be connected to the first signal processing board 610. Accordingly, the shielding cover 6003 may have a first electrical wire hole 60031 through which the first control board-side conducting wire 611 passes, and a second electrical wire hole 60032 through which the second control board-side conducting wire 612 passes.

In some embodiments, the shielding cover 6003 may have a third electrical wire hole 60033 through which a connection conducting wire 615 connecting the first signal processing board 610 to the second signal processing board 620 passes.

The first electrical wire hole 60031, the second electrical wire hole 60032, and the third electrical wire hole 60033 may each be provided to have a size corresponding to the specification of a conducting wire passing therethrough. When the shielding cover 6003 is assembled to the board mount 6002, corresponding conducting wires may be respectively inserted into the first electrical wire hole 60031, the second electrical wire hole 60032, and the third electrical wire hole 60033 so that only a very narrow gap may be formed. Thus, the shielding cover 6003 and the board mount 6002 may maintain shielding properties against internal electromagnetic waves.

According to an embodiment, the second signal processing board 620 may be installed on the board installation part 60012 provided on the base plate 6001.

The second signal processing board 620 may make electrical signals compatible between electrical circuits formed inside the grid-connected distribution box 1 or may make electrical signals of the load Load 1 or Load 2, which is connected to the grid-connected distribution box 1, compatible. As a specific example, the second signal processing board 620 may be provided as a typical interface board.

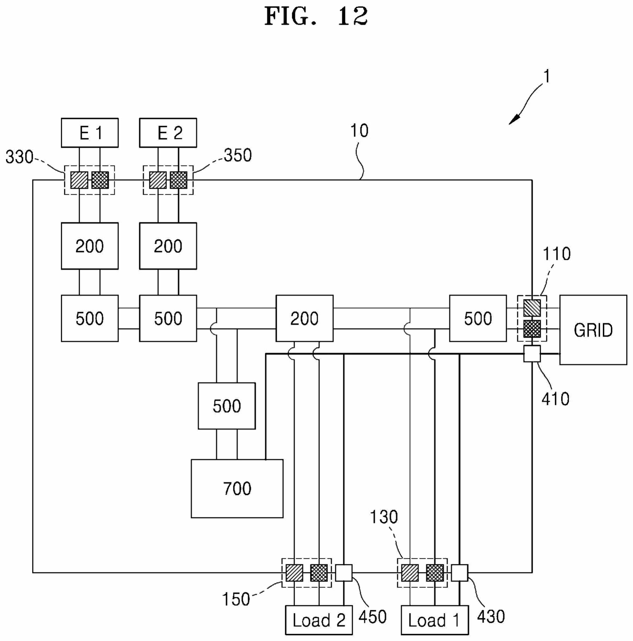

FIG. 12 is a schematic diagram illustrating a circuit of the grid-connected distribution box 1 of FIG. 2. Referring to FIGS. 1 to 12, the grid-connected distribution box 1 may be connected to a plurality of power supplies and may mutually exchange power supplied to a plurality of loads.

In the grid-connected distribution box 1 according to an embodiment of the present disclosure, a circuit for supplying main power applied from the main power supply GRID to the first load Load 1 and a circuit for supplying sub-power applied from the first sub-power supply E1 or the second sub-power supply E2 to the second load Load 2 may be provided to be separated from each other.

In this case, the grid-connected distribution box 1 may include a plurality of current sensors (not shown) to sense errors in the circuits. The control board 310 of the control module 300 may control the blocking module 500 according to a result sensed by the current sensor, thereby blocking a circuit section in which a problem has occurred.

According to an embodiment, main power supplied from the main power supply GRID may be input to the grid module 100 and the neutral module 400. In some embodiments, the active line of the main power supply GRID may be connected to the main input terminal 110, and the common neutral line of the main power supply GRID may be connected to the neutral input terminal 410.

As described above with reference to FIG. 7, the neutral module 400 may independently include a circuit that supplies, to a load, power applied through the neutral line of the main power supply GRID. For example, power applied to the common neutral line of the main power supply GRID may be input to the neutral input terminal 410 and output to the first neutral output terminal 430 and may be supplied to the first load Load 1 or output to the second neutral output terminal 450 to be supplied to the second load Load 2. Therefore, the description of a neutral line circuit of the neutral module 400 will be omitted below.

The grid-connected distribution box 1 may include a power supply circuit through which main power input to the main input terminal 110 is output to the first output terminal 130. Power may be supplied to the first load Load 1 through a circuit connected from the main input terminal 110 to the first output terminal 130.

According to an embodiment, sub-power supplied from the first sub-power supply E1 and the second sub-power supply E2 may be input to the control module 300. In some embodiments, the active line of the first sub-power supply E1 may be connected to the first sub-input terminal 330, and the active line of the second sub-power supply E2 may be connected to the second sub-input terminal 350.

The grid-connected distribution box 1 may include a power supply circuit through which sub-power input to the first sub-input terminal 330 is output to the second output terminal 150 through the relay module 200. Power may be supplied to the second load Load 2 through a circuit connected from the first sub-input terminal 330 to the second output terminal 150.

The grid-connected distribution box 1 may be equipped with a power supply circuit in which sub-power input to the second sub-input terminal 350 is output to the second output terminal 150 through the relay module 200. Power may be supplied to the second load Load 2 through a circuit connected from the second sub-input terminal 350 to the second output terminal 150.

Accordingly, in the grid-connected distribution box 1, the relay module 200 may be electrically connected to at least one of the first sub-power supply E1 and the second sub-power supply E2 to supply power to the second load Load 2. Accordingly, the grid-connected distribution box 1 may stably supply power to the second load Load 2 and prevent a power outage.

According to another embodiment, the grid-connected distribution box 1 may further include a power supply circuit through which main power input to the main input terminal 110 is output to the second output terminal 150 through the relay module 200. That is, the second load Load 2 may receive power input from the main power supply GRID or may receive power input from the first sub-power supply E1 and the second sub-power supply E2.

Accordingly, when a power outage occurs due to an abnormality in power of the main power GRID that is constantly supplied, the grid-connected distribution box 1 may stably supply power to the second load Load 2 through the first sub-power supply E1 and the second sub-power supply E2 and may prevent a power outage.

The present disclosure has been described with reference to embodiments shown in the accompanying drawings, but this is merely illustrative, and those skilled in the art will understand that various modifications and other equivalent embodiments are possible therefrom. Therefore, the true scope of the present disclosure should be determined only by the appended claims.

A grid-connected distribution box according to an embodiment of the present disclosure may include a structure in which communication processing and voltage conversion components are disposed at an upper portion of an enclosure, thereby facilitating assembly and repair work.

A grid-connected distribution box according to an embodiment of the present disclosure may be easily separated and partially replaced when a problem occurs in a specific communication processing and voltage conversion component, thereby improving convenience.

In a grid-connected distribution box according to an embodiment of the present disclosure, components constituting a distribution panel may be modularized according to functions thereof, thereby reducing a manufacturing time and improving efficiency and cost competitiveness.

A grid-connected distribution box according to an embodiment of the present disclosure may be connected to a plurality of power grids, and when an abnormality occurs in one grid, a power supply path may be switched to supply stable power to important loads, thereby reducing the possibility of a power outage and improving supply reliability.

## Claims

1. A grid-connected distribution box comprising:
a case having an internal space;
a grid module disposed in the internal space and having a main input terminal to which main power is input;
a control module disposed adjacent to the grid module and having a control board connected to the grid module and a sub-input terminal to which at least one sub-power is input;
a transformer installed in the internal space, connected to the control board, and configured to convert a voltage; and
a signal processing module disposed on the transformer to overlap the transformer, connected to the control board, and configured to process an electrical signal.

2. The grid-connected distribution box of claim 1, wherein the signal processing module comprises:
a base plate installed on the transformer;
a board mount which is disposed on the base plate and on which a first signal processing board is seated; and
a shielding cover covering an upper portion of the board mount.

3. The grid-connected distribution box of claim 2, wherein a second signal processing board is mounted on the base plate to be adjacent to the board mount and the shielding cover.

4. The grid-connected distribution box of claim 3, wherein the shielding cover has an electrical wire hole through which a conducting wire connecting the first signal processing board to the second signal processing board passes.

5. The grid-connected distribution box of claim 2, wherein an internal space provided by assembling the board mount and the shielding cover forms a shielding space configured to block electromagnetic wave radiation from the first signal processing board.

6. The grid-connected distribution box of claim 2, wherein the shielding cover comprises aluminum.

7. The grid-connected distribution box of claim 2, wherein the shielding cover has at least one electrical wire hole through which a conducting wire connecting the control board to the first signal processing board passes.

8. The grid-connected distribution box of claim 1, wherein the signal processing module is spaced apart from an inner peripheral surface of the case by a preset height.

9. The grid-connected distribution box of claim 1, wherein the signal processing module has a notch section in which a portion of a base plate installed on the transformer is cut to expose a plurality of terminals of the transformer.

10. The grid-connected distribution box of claim 1, further comprising a neutral module disposed adjacent to the control module to face the signal processing module.

11. The grid-connected distribution box of claim 10, wherein the neutral module and the signal processing module are disposed at opposite sides of the control module, and
the grid module is disposed along a side of the control module between the neutral module and the signal processing module.
